# EUROPEAN PATENT APPLICATION

(11) **EP 2 088 631 A1**
(43) Date of publication of application: **12.08.2009**
(21) Application number: 08151124.8
(22) Date of filing: 06.02.2008
(51) Int. Cl.: H01L 31/052, H05K 7/20, H05K 5/04

(54) **Concentrating photovoltaic apparatus**

(71) Applicant: Arima EcoEnergy Technologies Corporation, Dashi Town, Taoyuan 335 (TW)
(72) Inventor: Lee, Sen-Tien, 335, Taoyuan (TW); Tzeng, Yen-Chang, 335, Taoyuan (TW); Chen, Chi-Yuan, 335, Taoyuan (TW); Cheng, Chung-Chieh, 335, Taoyuan (TW)
(74) Representative: Viering, Jentschura & Partner

(57) **Abstract**

A concentrating photovoltaic (CPV) apparatus 20 includes at least one lens unit 30, at least one solar cell chip unit 40, and a frame structure 21. The frame structure 21 includes at least two opposite main walls 22, a plurality of upper and lower support bars 24-28 extended between and connected to the two main walls 22, and two sidewalls 29. The main walls 22 are each provided with at a predetermined position with at least one air opening 50 and at two lateral ends with a first and a second connecting portion 51, 52. Two ends of the upper and lower support bars 24-28 are connected to the first and the second connecting portions 51, 52, allowing the lens unit 30 and the solar cell chip unit 40 to be supported on and fixed to the upper and the lower support bars 24-28, respectively.

## Description

### FIELD OF THE INVENTION

The present invention relates to a concentrating photovoltaic (CPV) apparatus, and more particularly to a CPV apparatus with expandable and heat-dissipation frame structure.

### BACKGROUND OF THE INVENTION

With the gradually decreased oil reserve and production, solar energy available from the inexhaustible sunlight has been exploited and widely utilized by people now. To use solar energy, sunlight is caused to project on and absorbed by solar cell chips, so that solar energy is converted into electric energy for use. A concentrating photovoltaic (CPV) apparatus, which is usually briefly referred to as a solar cell, employs a relatively new technology for utilizing solar energy. In a CPV apparatus, a solar cell chip is a main device for converting light energy into electric energy. A group of light-focusing lenses is provided above the solar cell chip, so that sunlight projected thereto is focused on the solar cell chip. Since a CPV module consisting of one lens and one chip can only produce very low electric power, a plurality of lenses and chips may be particularly arrayed to thereby produce required amount of energy. The currently available CPV apparatus all are designed according to a specific Watts of power to be achieved.

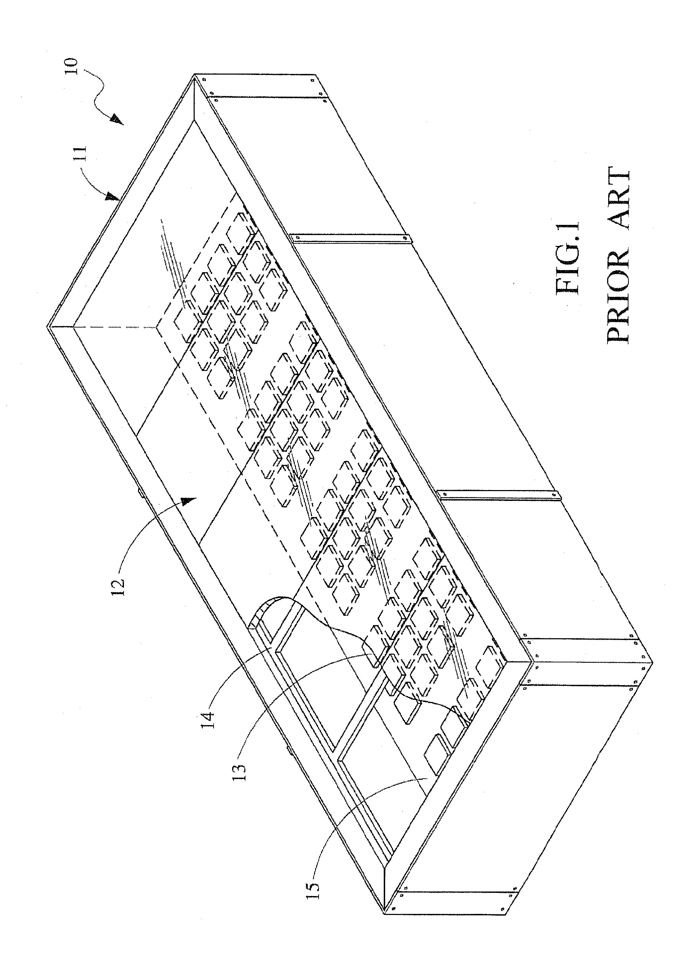

Fig. 1 is a perspective view of a conventional CPV apparatus 10, which includes a frame structure 11, a lens unit 12, and a solar cell chip unit 13. The frame structure 11 is constructed with extruded aluminum members. A support grid 14 is provided atop the frame structure 11 for supporting the lens unit 12 thereon, and a bottom plate 15 is mounted to a bottom of the frame structure 11 for holding the solar cell chip unit 13 thereon. The above-described frame structure 11 for the conventional CPV apparatus 10 has the following disadvantages: (1) the aluminum extrude members forming the frame structure 11 are not easily aligned with one another in assembling the frame structure 11; (2) the frame structure 11 is excessively heavy; (3) the frame structure 11 encloses a closed space and does not provide good heat dissipation; (4) the frame structure 11 is fixed in dimensions and could not be expanded.

Therefore, it is desirable to develop a CPV apparatus with an expandable and heat-dissipation frame structure.

### SUMMARY OF THE INVENTION

A primary object of the present invention is to provide a CPV apparatus having a frame structure that is expandable and allows good heat dissipation therefrom.

To achieve the above and other objects, the CPV apparatus according to the present invention includes at least one lens unit, at least one solar cell chip unit; and a frame structure. The frame structure includes at least two main walls, a plurality of upper and lower support bars longitudinally extended between and connected to the two main walls, and two sidewalls. Each of the two main walls is provided at a predetermined position with at least one air opening and at two lateral ends with a first and a second connecting portion. Two ends of the upper and lower support bars are connected to the first and the second connecting portions, so that the lens unit is supported by and fixed to the upper support bars and the solar cell chip unit is supported by and fixed to the lower support bars.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 is a perspective view of a conventional CPV apparatus;
Figs. 2 and 3 are assembled and exploded perspective views, respectively, of a CPV apparatus according to a first embodiment of the present invention;
Fig. 4 is a perspective view of a frame structure for the CPV apparatus of the present invention shown in Fig. 2;
Fig. 5 shows an expanded CPV apparatus of the present invention formed from two longitudinally connected CPV apparatus of Fig. 2 to construct a 1 x2 array;
Fig. 6 is a perspective view showing the frame structure for the expanded CPV apparatus of Fig. 5;
Fig. 7 shows another expanded CPV apparatus of the present invention formed from eight sidewardly connected CPV apparatus of Fig. 5 to construct an 8x2 array;
Fig. 8 is a perspective view showing the frame structure for the expanded CPV apparatus of Fig. 7; and
Fig. 9 is a perspective view sowing a CPV apparatus according to a second embodiment of the present invention.

### DETAILED DESCRIPTION OF THE PREFERRED EMBODIMENTS

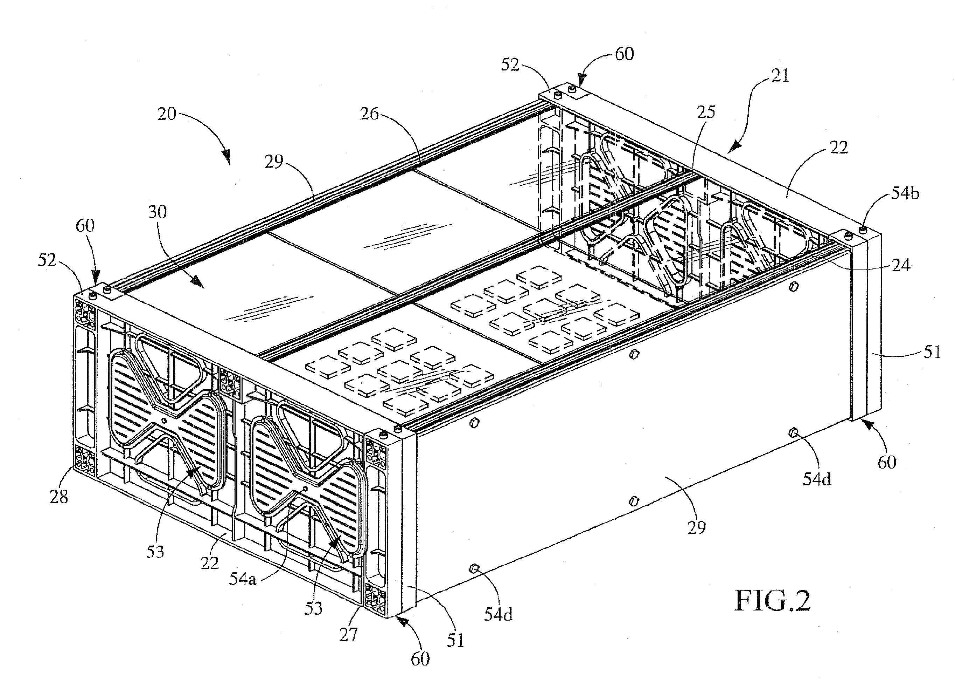

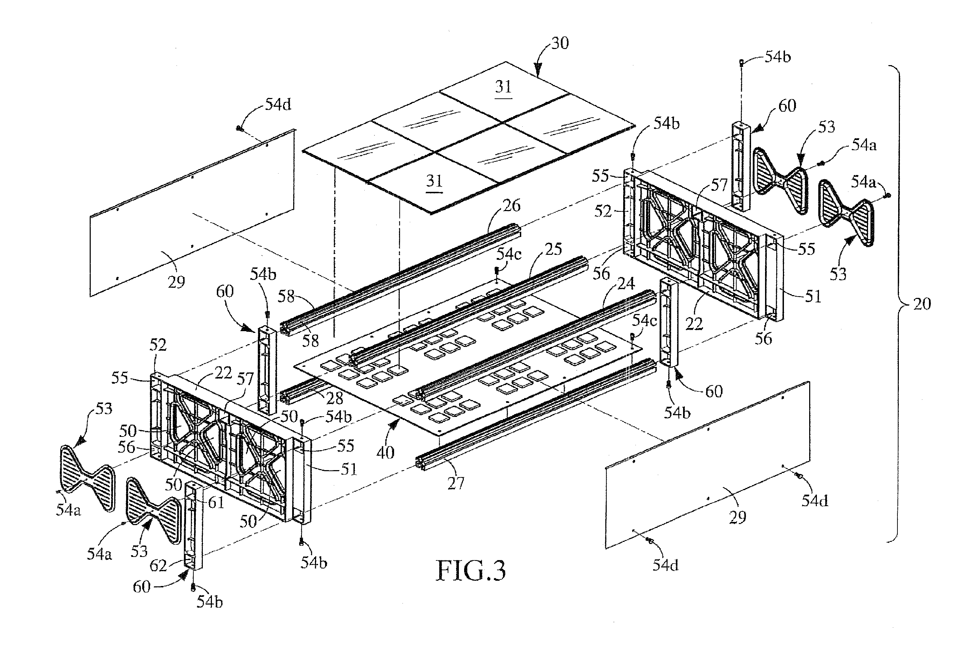

Please refer to Figs. 2 and 3 that are assembled and exploded perspective views, respectively, of a concentrating photovoltaic (CPV) apparatus 20 according to a first embodiment of the present invention. As shown, the CPV apparatus 20 includes a frame structure 21, a lens unit 30, and a solar cell chip unit 40.

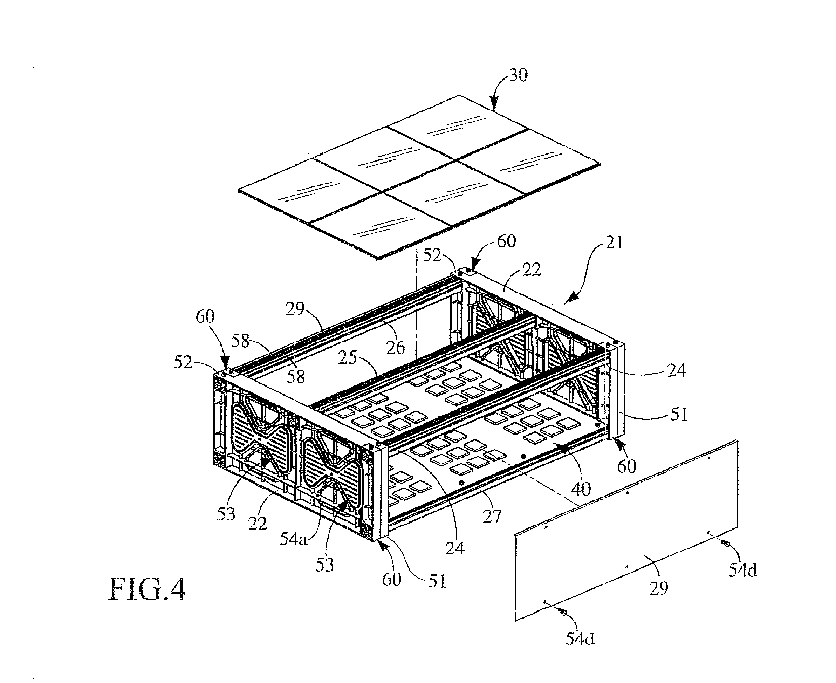

As can be seen from Fig. 4, the frame structure 21 includes at least two main walls 22, a plurality of upper support bars 24, 25, 26 (three are shown in the drawing), a plurality of lower support bars 27, 28 (two are shown in the drawing), and two sidewalls 29. The main walls 22 are made of a plastic material through injection molding, and are each provide at a predetermined position with at least one air opening 50 and at two lateral ends with a first and a second connecting portion 51, 52.

The frame structure 21 further includes an air ventilation plate 53 for mounting to each of the air openings 50 on the main walls 22. As can be seen from Fig. 3, in the illustrated embodiment, there are two air openings 50 provided on each of the two main walls 22, and the air ventilation plates 53 are separately fixed to an outer side of the air openings 50 using fastening elements 54a. With the air ventilation plates 53, reduction in energy conversion efficiency and condensation of moisture on an underside of the lens unit 30 possibly caused by temperature rise under strong sunlight can be prevented.

In the first embodiment of the present invention, the first connecting portion 51 and the second connecting portion 52 at two lateral ends of each main wall 22 are located at two opposite sides of a transverse centerline of the main wall 22 to extend parallel to each other in two opposite directions. The first and second connecting portions 51, 52 are each provided with an upper and a lower receiving hole 55, 56 located in the same vertical axis. Moreover, the main walls 22 are each provided with a middle upper receiving hole 57, which and the upper receiving holes 55 are located in the same horizontal axis.

The frame structure 21 further includes a plurality of complementary members 60, which may be associated with the first and second connecting portions 51, 52 to complete the lateral ends of the main walls 22. As can be seen in Figs. 3 and 4, the complementary members 60 are each provided with an upper receiving hole 61 and a lower receiving hole 62 corresponding to the upper and the lower receiving hole 55, 56, respectively, on the first and second connecting portions 51, 52. The complementary members 60 are also made of a plastic material through injection molding.

Please refer to Fig. 3. The upper support bars 24-26 are connected to the two main walls 22 with two ends separately received in the upper receiving holes 55, 57. Similarly, the lower support bars 27, 28 are connected to the two main walls 22 with two ends separately received in the lower receiving holes 56, 62. Then, the upper support bars 24-26 and the lower support bars 27, 28 are fastened to the first and second connecting portions 51, 52 and the complementary members 60 using fastening elements 54b, so that the upper support bar 24 and the lower support bar 27 are parallel to each other, and the upper support bar 26 and the lower support bar 28 are parallel to each other. In the present invention, the upper support bars 24-26 and the lower support bars 27, 28 are made of aluminum extrusions having identical structure and dimensions. The upper support bars 24-26 and the lower support bars 27, 28 are each formed along their two upper lateral edges with an elongate lip portion 58 each. As shown in Fig. 4, lenses 31 in the lens unit 30 are supported on and between two adjacent upper support bars 24, 25 or 25, 26 with two lateral edges of the lenses 31 received in two facing lip portions 58 separately located on the two adjacent upper support bars 24, 25 or 25, 26. Meanwhile, the solar cell chip unit 40 is supported on and between the two lower support bars 27, 28 in the same manner as the lens unit 30 and then fixed to the lower support bars 27 28 using fastening elements 54c.

The two sidewalls 29 are separately located at two lateral sides of the frame structure 21 by fixing them to outer sides of the upper and lower support bars 24, 27 and 26, 28 using a plurality of fastening elements 54d.

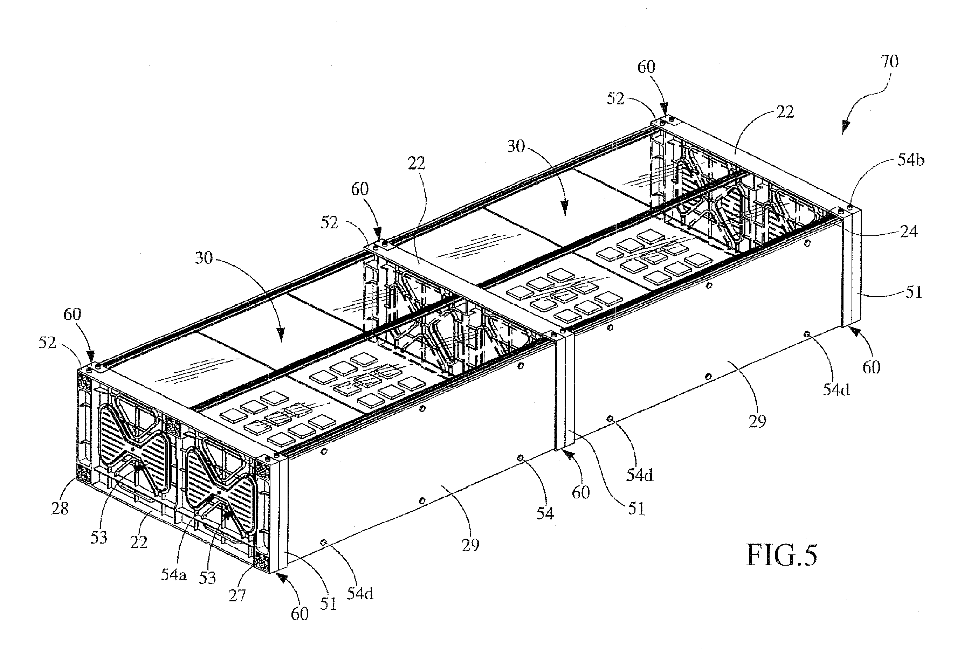

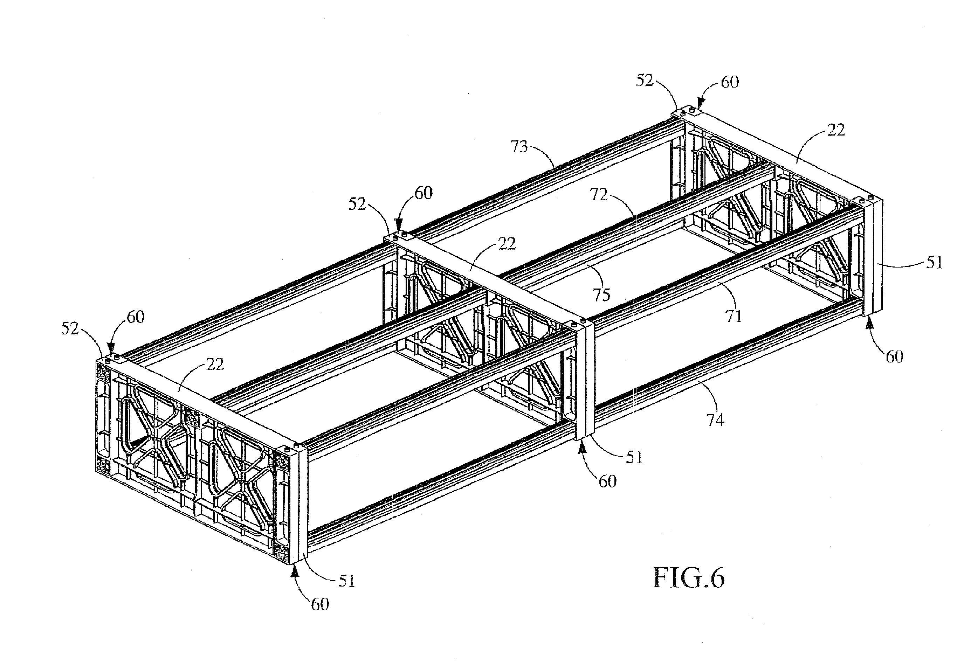

The CPV apparatus 20 may be considered as a smallest unit of the CPV apparatus of the present invention. Two or more of the CPV apparatus 20 may be longitudinally or sidewardly connected to form an expanded CPV apparatus. For example, according to a required output power, a plurality of the CPV apparatus 20 may be longitudinally and/or sidewardly sequentially connected to one another to construct a 1x2 array, a 1x16 array, a 2x8 array, a 4x4 array, an 8x2 array, and the like to provide a different output power each. Fig. 5 shows an expanded CPV apparatus 70 that is formed by longitudinally connecting two CPV apparatus 20 to construct a 1x2 array; and Fig. 6 is a perspective view of the frame structure for the expanded CPV apparatus 70. As can be clearly seen from Figs. 5 and 6, the frame structure for the CPV apparatus 70 has main walls 22 and complementary members 60 the same as that in the frame structure in their configurations, dimensions, and other components thereof. However, to enable the forming of a longitudinally expanded CPV apparatus, the upper and the lower support bars have various lengths. Therefore, upper and lower support bars of different lengths may be selected for use according to the number of the smallest units of CPV apparatus 20 to be longitudinally connected together. For the expanded CPV apparatus 70 in the form of a 1x2 array, three pieces of the main walls 22 are separately transversely fixed to front ends, middle points, and rear ends of the lengthened upper support bars 71-73 and lower support bars 74, 75, so that two lenses units 30 are supported on and fixed to the upper support bars 71-73, and two solar cell chip units (not numbered in Fig. 5 and not shown in Fig. 6) are supported on and fixed to the lower support bars 74, 75.

Again, each of the first and second connecting portions 51, 52 has one complementary member 60 associated therewith.

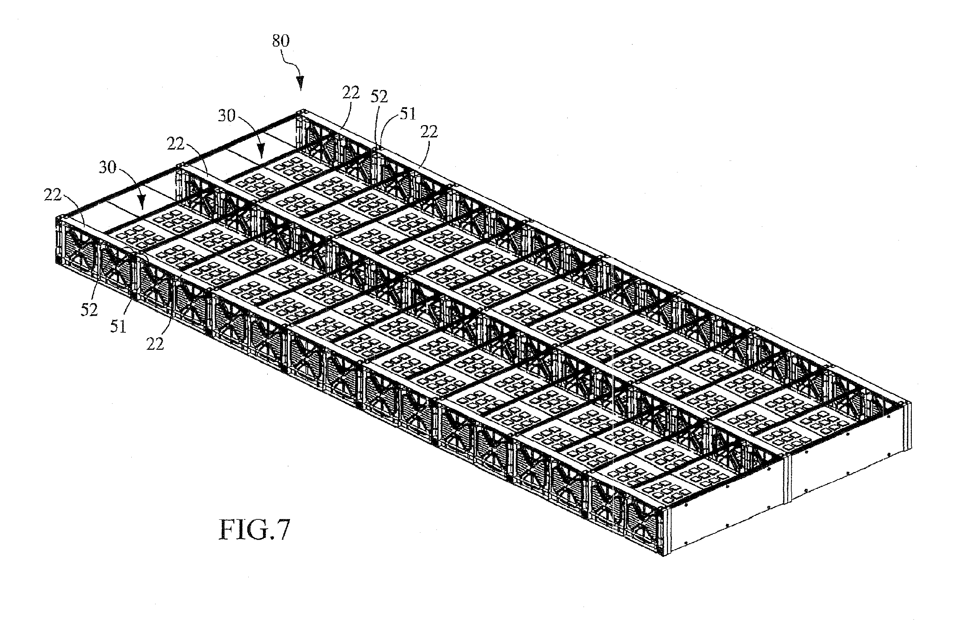

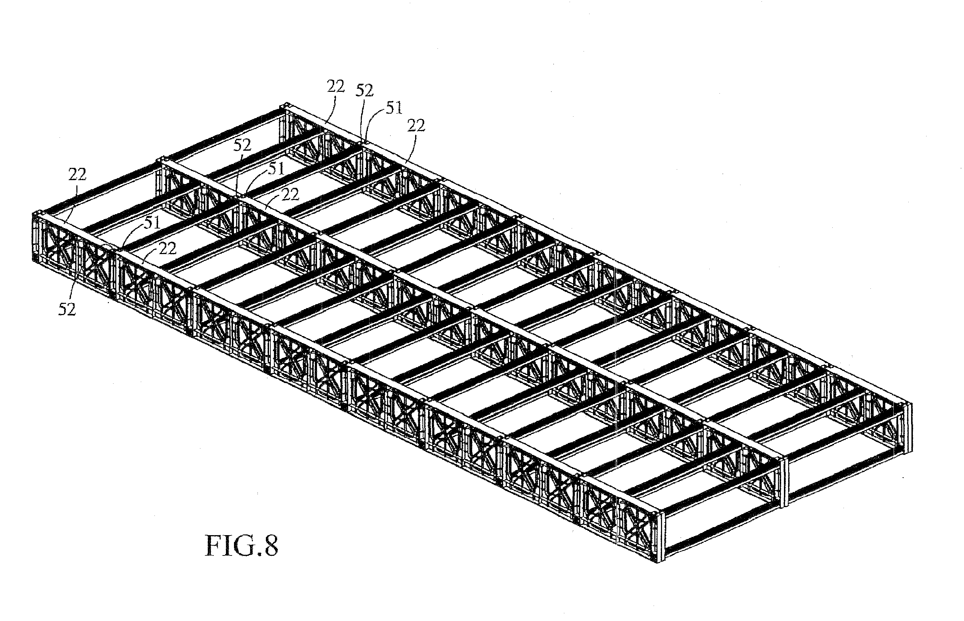

Two or more of the expanded CPV apparatus 70 in the form of a 1x2 array as shown in Fig. 5 may be sidewardly connected together. Please refer to Fig. 7 that shows an expanded CPV apparatus 80 formed by sidewardly connecting eight pieces of CPV apparatus 70 to construct an 8x2 array, and to Fig. 8 that is a perspective view of the frame structure for the expanded CPV apparatus 80. To achieve the expanded CPV apparatus 80 from a plurality of sidewardly connected CPV apparatus 70, the first connecting portions 51 on the three main walls 22 of a first CPV apparatus 70 and the second connecting portions 52 on the three main walls 22 of an adjoining second CPV apparatus 70 are lapped and fastened together using fastening elements. Repeat the above lapping and fastening at the first and the second connecting portions on two parallelly arranged CPV apparatus 70 to complete the extending of the main walls 22 sidewardly. Finally, fix the lens units 30 and the solar cell chip units (not numbered in Fig. 7 and not shown in Fig. 8) to the upper support bars and the lower support bars, respectively. In lapping the first and the second connecting portions of two sidewardly adjoining main walls 22, the complementary members 60 are actually omitted. The complementary members 60 are only associated with the first and the second connecting portions located at two outmost lateral sides of the expanded CPV apparatus 80.

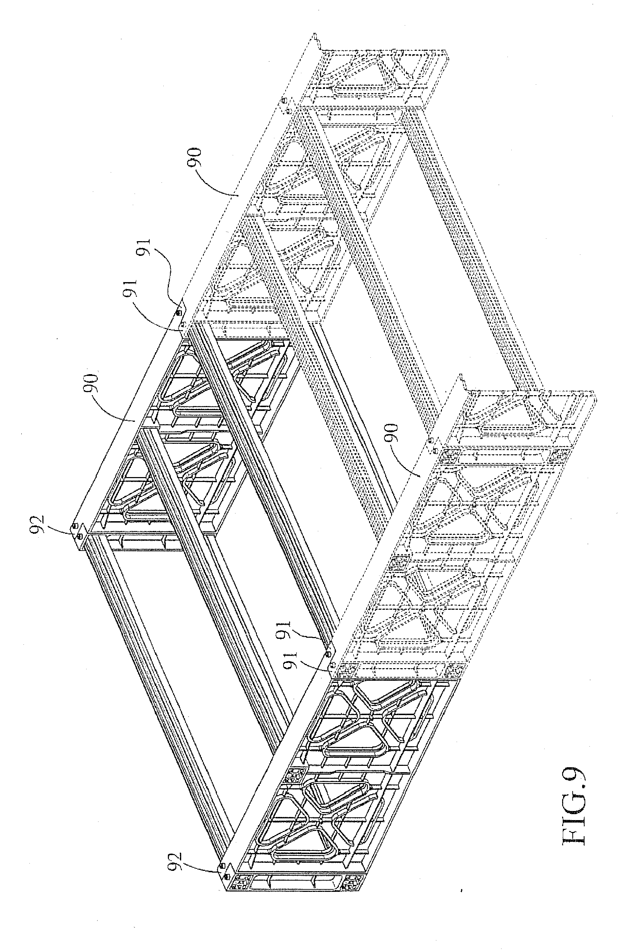

Fig. 9 is a perspective view showing a CPV apparatus according to a second embodiment of the present invention. The CPV apparatus in the second embodiment includes main walls 90 having a first connecting portion 91 and a second connecting portion 92 each. The first and second connecting portions 91, 92 are located at the same side of a transverse centerline of the main wall 90. To enable two smallest units of the CPV apparatus according to the second embodiment of the present invention to be sidewardly connected to form an expanded CPV apparatus, first horizontally turn the main walls 90 of a second CPV apparatus unit by 180 degrees to a position as indicated by phantom lines in Fig. 9, and then extend two ends of the upper support bars into the upper receiving holes on the main walls to lap and join the facing first and second connecting portions 91, 92 on the two units of CPV apparatus with one another. Thereafter, the lapped first and second connecting portions 91, 92 are tightened using fastening elements. By repeating the above steps, a plurality of the CPV apparatus according to the second embodiment of the present invention may be sidewardly connected to construct an expanded CPV apparatus.

The CPV apparatus of the present invention provides the following advantages:
(1) The plastic injection-molded main walls and the aluminum extruded upper and lower support bars are easy to align with one another in the process of assembling the frame structure, allowing easy establishment of reference planes for mounting the solar cell chip unit and the lens unit;
(2) The frame structure has a reduced overall weight;
(3) The frame structure is provided with air openings to allow air convection and prevent condensate from forming at the underside of the lenses; and
(4) The CPV apparatus may be longitudinally and/or sidewardly connected to form an expanded CPV apparatus according to required output power.

The present invention has been described with some preferred embodiments thereof and it is understood that many changes and modifications in the described embodiments can be carried out without departing from the scope and the spirit of the invention that is intended to be limited only by the appended claims.

## Claims

1. A concentrating photovoltaic (CPV) apparatus 20, comprising:
at least one lens unit 30 including a plurality of lenses 31;
at least one solar cell chip unit 40; and
a frame structure 21 including at least two opposite main walls 22 and a plurality of upper and lower support bars 24-28 extended between and connected to the two main walls 22;
wherein the main walls 22 are each provided with at a predetermined position with at least one air opening 50, and at two lateral ends with a first and a second connecting portion 51, 52; the upper support bars 24-26 are connected to the two main wal!s 22 by extending two ends of the upper support bars 24-26 into the first and the second connecting portions 51, 52 of the main walls 22; the lens unit 30 is supported on and fixed to the upper support bars 24-26; and the solar cell chip unit 40 is supported on and fixed to the lower support bars 27, 28.

2. The CPV apparatus 20 as claimed in claim 1, wherein the frame structure 21 further includes at least one air ventilation plate 53 for mounting to an outer side of the at least one air opening 50 on each of the main walls 22.

3. The CPV apparatus 20 as claimed in claim 1, wherein the first and the second connecting portion 51, 52 at the two lateral ends on the same main wall 22 are located at two opposite sides of a transverse centerline of the main wall 22.

4. The CPV apparatus 20 as claimed in claim 1, wherein the first and the second connecting portion 51, 52 at the two lateral ends on the same main wall 22 are located at the same side of a transverse centerline of the main wall 22.

5. The CPV apparatus 20 as claimed in claim 1, wherein the first and the second connecting portion 51, 52 on each main wall 22 are provided with an upper receiving hole 55 and a lower receiving hole 56 each, and the upper and the lower receiving hole 55, 56 on each of the first and the second connecting portions 51, 52 are located in the same vertical axis; and
wherein the main walls 22 are each provided with a middle upper receiving hole 57, which and the two upper receiving holes 55 on the first and the second connecting portion 51, 52 are located in the same horizontal axis.

6. The CPV apparatus 20 as claimed in claim 3, wherein the first connecting portions 51 on the two main walls 22 of a first frame structure may be lapped with and connected to the second connecting portions 52 on the main walls 22 of a second frame structure to enable sideward expansion of the CPV apparatus 80.

7. The CPV apparatus 20 as claimed in claim 4, wherein the first connecting portions 91 on the two main walls 90 of a first frame structure may be lapped with and connected to the second connecting portions 92 on the main walls 90 of a second frame structure to enable sideward expansion of the CPV apparatus.

8. The CPV apparatus 20 as claimed in claim 1, wherein the frame structure 21 further includes a plurality of complementary members 60 for separately associating with the first and second connecting portions 51, 52, allowing the two lateral ends of the main walls 22 to have a complete structure each.

9. The CPV apparatus 20 as claimed in claim 8, wherein the complementary members 60 are each provided with an upper and a lower receiving hole 61, 62 corresponding to the upper and the lower receiving holes 55, 56 on the first and the second connecting portions 51, 52.

10. The CPV apparatus 20 as claimed in claim 1, wherein the upper support bars 24-26 are each provided along two upper lateral sides with an elongate lip portion 58 each, and the lens unit 30 are supported on and fixed to the upper support bars 24-26 with two lateral edges of each lens 31 in the lens unit 30 received in two facing lip portions 58 separately located on two adjacent upper support bars 24, 25 or 25, 26.

11. The CPV apparatus 20 as claimed in claim 1, wherein the frame structure 21 further includes two sidewalls 29 separately fixed to outer sides of two laterally outermost pairs of upper and lower support bars 24-28.

12. The CPV apparatus 20 as claimed in claim 1, wherein the upper and the lower support bars 24-28 have various lengths to enable longitudinal connection of two or more frame structures to form a longitudinally expanded CPV apparatus.
